# EUROPÄISCHE PATENTSCHRIFT

(11) **EP 0 278 566 B1**
(45) Veröffentlichungstag und Bekanntmachung des Hinweises auf die Patenterteilung: **14.09.1994**
(21) Anmeldenummer: 88200197.7
(22) Anmeldetag: 04.02.1988
(51) Int. Cl.: H04H 7/00, H03K 17/16, H03K 17/62

(54) **Schaltungsanordnung zum wahlweisen Verbinden von Signalquellen mit einer Signalsenke**
Circuit arrangement for the selective connection of signal sources to a signal collector
Dispositif de connexion sélective de sources de signaux avec un collecteur de signal

(30) Priorität: 07.02.1987 DE 3703785
(43) Veröffentlichungstag der Anmeldung: 17.08.1988
(73) Patentinhaber: Philips Patentverwaltung GmbH, 22335 Hamburg (DE); Philips Electronics N.V., 5621 BA Eindhoven (NL)
(72) Erfinder: Schwarz, Henning, D-2057 Reinbek (DE); Weltersbach, Wolfgang, D-2000 Hamburg 54 (DE)
(74) Vertreter: Peters, Carl Heinrich, Dipl.-Ing.

(56) Entgegenhaltungen:
- DE-B- 2 506 034
- US-A- 3 641 365
- US-A- 4 581 541
- PATENT ABSTRACTS OF JAPAN, Band 11, Nr. 341 (E-554), 7. November 1987 & JP-A- 62122321
- PATENT ABSTRACTS OF JAPAN, Band 7, Nr. 154 (E-185), 6. Juli 1983 & JP-A- 58062936

## Beschreibung

Die Erfindung bezieht sich auf eine Schaltungsanordnung zum wahlweisen Verbinden der Ausgänge einer Anzahl von aus Gleich- und Wechselanteilen betehende Signale liefernden Signalquellen mit einem Eingang einer Signalsenke nach dem Oberbegriff des Hauptanspruchs.

Derartige Schaltungsaordnungen sind aus dem Bereich der Nachrichtentechnik grundsätzlich bekannt. Sie werden beispielsweise in der Audio- oder Videotechnik als Quellenumschalter eingesetzt, durch die eine Anzahl von Audio- oder Videosignalquellen mit einer entsprechenden Wiedergabeanordnung verbunden werden kann.

Bei Signalen mit einem Gleich- und einem Wechselanteil treten beim Umschalten einer Verbindung in einer derartigen Anordnung von einer Signalquelle auf eine andere Störungen auf, die sich insbesondere bei der Übertragung von Tonsignalen duch Knackgeräusche äußern, die bei ungünstigen Wiedergabebedingungen für einen Zuhörer äußerst unangenehm sein können. Entsprechende Störungen bei der Verarbeitung von Videosignalen und anderem sind ebenso unerwünscht.

Aus der DE-A-2 506 034 ist eine Schaltungsanordnung zum elektronischen Durchschalten von wenigstens einer Wechselspannung an einen gemeinsamen Ausgang bekannt, die wenigstens ein mit Halbleitern bestücktes Dämpfungsglied aufweist, dessen Eingang über einen Kondensator an eine Wechselspannungsquelle anschließbar ist und dessen Dämpfung durch ein Steuersignal von einem hohen Wert auf einen niedrigen Wert umschaltbar ist, wobei bei fehlender bzw. niedriger Dämpfung am Eingang ein Gleichstrom fließt. Zum Ausbilden dieser Schaltungsanordnung für ein einwandfreies Umschalten ohne sperrendes Knacken bleibt beim Umschalten der Dämpfung des Dämpfungsgliedes dessen Eingangsgleichspannung praktisch unverändert, indem die Schaltungsanordnung so ausgebildet ist, daß das Dämpfungsglied wenigstens zwei wechselstrommäßig hintereinander geschaltete Transistoren enthält, die bei fehlender bzw. geringer Dämpfung beide von einem Gleichstrom durchflossen werden, während bei hoher Dämpfung nur der erste am Eingang liegende Transistor vom Gleichstrom durchflossen wird.

Die Erfindung hat die Aufgabe, eine weitere Schaltungsanordnung zu schaffen, durch die die beschriebenen Störungen vermieden werden.

Die Aufgabe wird bei einer Schaltungsanordnung der eingangs genannten Art erfindungsgemäß durch die kennzeichnenden Merkmale des Hauptanspruchs gelöst.

Bei der erfindungsgemäßen Schaltungsanordnung tritt beim Umschalten von einer Signalquelle auf eine andere ein die vorgenannten Störungen verursachender Gleichspannungsprung nicht mehr auf. Bei dieser Anordnung steuert der - gegebenenfalls schwankende - Gleichanteil des Signales einer Signalquelle den Strom der Bezugsquelle. Die an den Ausgängen beider Quellen abgegebenen Gleichspannungen stimmen stets überein. Durch Kombination mit der im Anschluß genannten Ausführungsform der Erfindung kann weiterhin eine Anordnung geschaffen werden, in der eine von einer Signalquelle nachgeführte Bezugsquelle die Gleichanteile weiterer Signalquellen einstellt. Der die Bezugsquelle bildende Ausgangsanschluß kann zum Abtrennen des eingeprägten Gleichstroms und zum Unterdrücken weiterer Signalanteile mit einer an sich bekannten Siebschaltung verbunden sein. Die Ausgangsanschlüsse der Signalverarbeitungsstufe sind bevorzugt durch eine Stromspiegelanordnung gebildet. Diese ermöglicht in einfacher Weise eine Entkopplung der Ausgangsanschlüsse und gleichzeitig eine Abgabe streng korrelierter Gleichanteile.

An dieser Stelle sei bemerkt, daß es grundsätzlich bekannt ist, bei der Übertragung eines Signales durch einen Trennkondensator oder einen Trenntransformator Gleichanteile zu unterdrücken und nur Wechselanteile weiterzuleiten. Eine derartige Vorgehensweise ist jedoch nicht angezeigt, wenn der Gleichanteil eines Signales mitübertragen werden soll oder die genannten Bauelemente die Signalübertragungseigenschaften der Verbindung zwischen Signalquelle und Signalsenke ungünstig beeinflussen oder einen zu hohen Schaltungsaufwand hervorrufen, wie z. B. bei einem angestrebten Aufbau in einer integrierten Schaltungsanordnung.

In einer Ausgestaltung der Erfindung liefert eine der Signalquellen als Bezugsquelle eine Gleichspannung und sind mit den Ausgängen weiterer der Signalquellen Gleichspannungs-Einstellschaltungen verbunden, durch die die Gleichanteile der Signale an den Ausgängen der Signalquellen auf die Gleichspannung der Bezugsquelle eingestellt werden. Dadurch wird verhindert, daß sich die Gleichanteile der Signale nicht durch Signalschwankungen, Drift oder ähnliches in unterschiedlichem Maß verändern. Außer-dem können die Gleichanteile an durch die Bezugsquelle repräsentierte Schwankungen angepaßt werden, womit beispielsweise gemeinsame Arbeitspunktregelungen und dergleichen ermöglicht werden.

Die vorstehend beschriebenen Schaltungsanordnungen ermöglichen durch wahlweises Verbinden des Ausgangs der Bezugsquelle einerseits oder der Ausgänge der übrigen Signalquellen andererseits mit der Signalsenke auch ein störungsfreies Abschalten der (übrigen) Signalquellen. Damit kann z. B. in der Audiotechnik ein "knackfreies" Stummschalten von Tonsignalquellen erzielt werden, wie durch die Erfindung allgemein ein "knackfreies" Umschalten zwischen den einzelnen Tonsignalquellen ermöglicht wird.

Vorteilhaft ist weiterhin eine Steuerschaltung vorgesehen, der ein Quellenauswahlsignal zugeführt wird und die danach den Eingang der Signalsenke mit dem Ausgang einer ausgewählten Signalquelle verbindet, und der wenigstens ein Stummschaltesignal zugeleitet wird, durch das sie den Eingang der Signalsenke vorrangig mit dem Ausgang der Bezugsquelle verbindet. Die Steuerschaltung kombiniert somit eine Auswahl einer gewünschten Signalquelle mit dem "Stummschalten" aller Signalquellen, wobei die Wortwahl für das letztere keine Beschränkung auf Tonsignale beinhaltet. Das "Stummschalten" erfolgt vorrangig vor einer Auswahl einer der übrigen Signalquellen, und zwar vorzugsweise dann, wenn die ausgewählte Signalquelle kein Signal liefert, wenn im Signal auszublendende Störungen auftreten oder auch bei einem Wechsel der Signalquelle und dann z. B. nur kurzzeitig. Das Stummschaltesignal kann entsprechend auf unterschiedliche Weise erzeugt werden, beispielsweise von einer Störerkennungsschaltung oder anderen externen Vorrichtungen. Bevorzugt wird das Stummschaltesignal von der Signalverarbeitungsstufe erzeugt, wenn die durch sie gebildete Signalquelle kein Signal abgibt.

Die übrigen Unteransprüche nennen weitere vorteilhafte Ausgestaltungen der Erfindung.

Ein Ausführungsbeispiel der Erfindung ist in der Zeichnung dargestellt und wird im nachfolgenden näher beschrieben. Es zeigen
- Fig. 1: das schematische Schaltbild einer Anordnung, in der die Erfindung angewendet wird,
- Fig. 2: ein schematisches Schaltbild zum Einsatz der Anordnung nach Fig. 1.

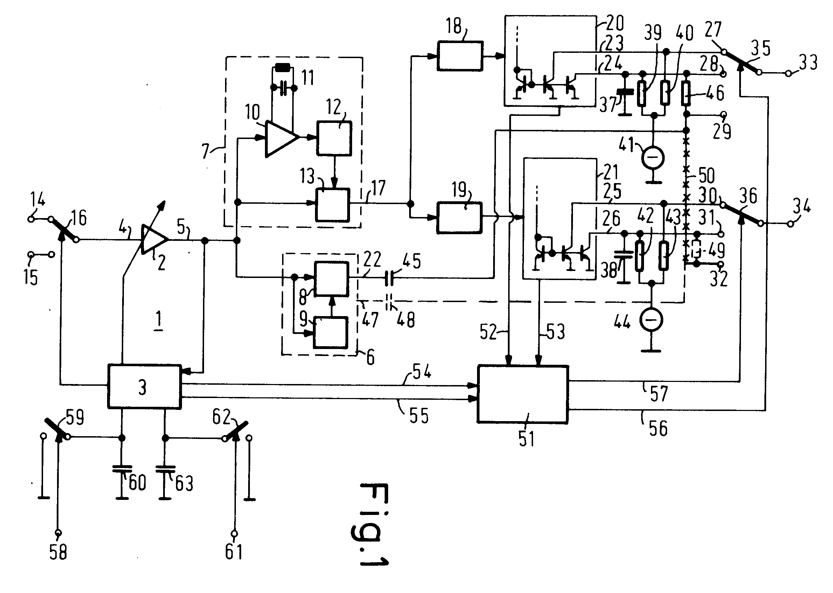

Fig. 1 zeigt als Anwendungsbeispiel für die Erfindung einen Ausschnitt aus einer Schaltungsanordnung zur Verarbeitung eines Tonsignales in einer Mehrnormen-Fernseh-Empfangsanordnung. Diese umfaßt eine Amplitudenregelanordnung 1 aus einem Verstärker 2 mit einstellbarer Verstärkung und einer Regelsignalerzeugungsstufe 3. Das dem Eingang 4 des Verstärkers 2 zugeleitete, auf eine Zwischenfrequenz modulierte Signal wird im Verstärker 2 in an sich bekannter Weise um einen Verstärkungsfaktor verstärkt, dessen Wert aus dem Signal am Ausgang 5 des Verstärkers 2 von der Regelsignalerzeugungsstufe 3 abgeleitet wird.

Vom Ausgang 5 des Verstärkers 2 wird das in seiner Amplitude geregelte Signal einem Synchrondemodulator 6 und einem Quadraturdemodulator 7 zugeführt. Der Synchrondemodulator 6 umfaßt einen Multiplizierer 8 und einen Begrenzerverstärker 9, der Quadraturdemodulator 7 einen frequenzselektiven Referenzverstärker 10 mit einem Filterkreis 11, einen Begrenzerverstärker 12 und einen Multiplizierer 13.

Der Schaltungsanordnung nach Fig. 1 wird an einem ersten Zwischenfrequenzeingang 14 ein erstes Zwischenfrequenzsignal und an einem zweiten Zwischenfrequenzeingang 15 ein zweites Zwischenfrequenzsignal zugeführt. Das erste Zwischenfrequenzsignal ist im vorliegenden Ausführungsbeispiel ein Gemisch aus einem oder aus zwei mit Tonsignalen frequenzmodulierten, zwischenfrequenten Trägern und einem Zwischenfrequenz-Bildträger, das zweite Zwischenfrequenzsignal umfaßt einen mit einem Tonsignal amplitudenmodulierten Zwischenfrequenzträger. Damit entspricht z. B. das erste Zwischenfrequenzsignal der PAL- oder der NTSC-Norm, das zweite Zwischenfrequenzsignal der SECAM-L-Norm. Diese Signale werden wahlweise über einen Umschalter 16 der Amplitudenregelanordnung 1 zugeleitet.

Der Quadraturdemodulator 7 setzt das erste Zwischenfrequenzsignal mit Hilfe des Zwischenfrequenzbildträgers nach dem Intercarrier-Verfahren in ein weiteres frequenzmoduliertes Signal an seinem Ausgang 17 um, das zu jedem zwischenfrequenten Träger im ersten Zwischenfrequenzsignal ein frequenzmoduliertes Tonsignal aufweist. Die frequenzmodulierten Tonsignale werden über Bandpaßfilter 18, 19 voneinander getrennt und durch Frequenzdemodulatoren 20, 21 in niederfrequente Tonsignale umgewandelt, die über Anschlüsse 23, 24 bzw. 25, 26 abgegeben werden.

Das zweite Zwischenfrequenzsignal wird im Synchrondemodulator 6 demoduliert, an dessen Anschluß 22 ein niederfrequentes Tonsignal erscheint.

Die Anschlüsse 22 bis 24 bzw. 22, 25, 26 stellen Signalquellen dar, deren Ausgänge 27 bis 29 bzw. 30 bis 32 wahlweise mit zwei Eingängen 33 bzw. 34 zweier Signalsenken über Quellenumschalter 35, 36 verbindbar sind.

Die Anschlüsse 23 und 24 bzw. 25 und 26 werden im gezeigten Ausführungsbeispiel durch die Kollektoren zweier parallel angesteuerter Stromspiegeltransistoren in jedem der Frequenzdemodulatoren 20, 21 gebildet, so daß die Ströme in den Anschlüssen 23 und 24 bzw. den Anschlüssen 25 und 26 jeweils zueinander im konstanten Verhältnis stehen. Während die Anschlüsse 23 bzw. 25 Signalquellen zur Lieferung von Tonsignalen bilden, dienen die Anschlüsse 24, 26 als Bezugsquellen, die einen eingeprägten Gleichstrom liefern, der aus den Gleichanteilen der Ströme der Anschlüsse 23 bzw. 25 abgeleitet ist. Dazu sind die Anschlüsse 24 bzw. 26 über einen ersten bzw. zweiten Siebkondensator 37, 38 mit Masse verbunden, wodurch die Tonsignale kurzgeschlossen werden. Weiterhin sind die Anschlüsse 23 und 24 über je einen Widerstand 39, 40 mit einer Referenzspannungsquelle 41 verbunden, entsprechend sind die Anschlüsse 25, 26 über je einen Widerstand 42, 43 mit einer weiteren Referenzspannungsquelle 44 verbunden. Bedingt durch die Siebkondensatoren 37, 38 liegen an den Ausgängen 28 und 31 Gleichspannungen,da die Referenzspannungsquellen 41, 44 ebenfalls Gleichspannungen abgeben. Die Widerstandswerte für die Widerstände 39, 40 bzw. 42, 43 sind derart gewählt, daß die Produkte aus Gleichstrom und Widerstandswert, d. h. die an den Widerständen anliegenden Gleichspannungen, für die Anschlüsse 23 und 24 bzw. 25 und 26 jeweils gleich sind. Die Ausgänge 27 und 28 bzw. 30 und 31 führen also identische Gleichspannungen bzw. Gleichanteile.

Die Gleichspannungen bzw. Gleichanteile an den Ausgängen der Frequenzdemodulatoren 20, 21 sind u. a. von den Phasenlagen der frequenzmodulierten Tonsignale abhängig und können im Betrieb der beschriebenen Schaltungsanordnung schwanken.Da jedoch die Gleichspannung der Bezugsquelle 24 bzw. 26 stets dem Gleichanteil der Signalquelle 23 bzw. 25 nachgeführt wird, tritt unabhängig vom Betriebszustand beim Umschalten vom Ausgang 27 zum Ausgang 28 bzw. vom Ausgang 30 zum Ausgang 31 kein Gleichspannungsprung und damit keine Störung auf. Ein solches Umschalten kann daher bevorzugt als störungs- bzw. knackfreies Stummschalten ausgenutzt werden.

Vom Anschluß 22 wird das dort anliegende niederfrequente Tonsignal über einen Koppelkondensator 45 den Ausgängen 29 und 32 zugeführt, denen über einen Widerstand 46 die Gleichspannung von der Bezugsquelle 24 eingespeist wird. Damit wird ein störungsfreies Umschalten auch bezüglich der Ausgänge 29, 32 erreicht. Vorzugsweise werden dafür die von den Bezugsquellen 24, 26 abgegebenen Gleichspannungen übereinstimmen.

Die beschriebene Anordnung ist zur Verarbeitung von Stereo- bzw. Zweitonsignalen eines Fernsehsignales z. B. nach der B/G-Norm und eines einfachen Tonsignals nach der L-Norm eingerichtet. Die Signalsenken bilden die Stereo-bzw. Zweitonkanäle der Fernsehempfangsanordnung. In einer Abwandlung kann die Schaltungsanordnung auch für Stereo-oder Zweiton-Signale eines Fernsehsignals der L-Norm verwendet werden. Ein entsprechend abgewandelter Synchrondemodulator 6 weist dann einen zweiten Anschluß 47 auf, von dem ein zweites niederfrequentes Tonsignal über einen zweiten Koppelkondensator 48 dem Ausgang 32 zugeführt wird. Über einen zusätzlichen Widerstand 49 wird die Gleichspannung von der Bezugsquelle 26 dem Ausgang 32 eingespeist, und die Leitung 50 zwischen den Ausgängen 29 und 32 ist dann unterbrochen. Im übrigen kann eine derartige Anordnung auch zur Verarbeitung eines einfachen niederfrequenten Tonsignals verwendet werden, wenn der zweite Koppelkondensator 28 ebenfalls mit dem Anschluß 22 verbunden ist. Dann machen sich Toleranzen bei der Einstellung der Gleichspannungen der Bezugsquellen 24 und 26 nicht mehr ungünstig bemerkbar.

Beim vorliegenden Ausführungsbeispiel bilden die Quellenumschalter 35, 36 zusammen mit einem Logikteil 51 eine Steuerschaltung zum wahlweisen Verbinden der Bezugsquellen und der Signalquellen für die Tonsignale mit den Signalsenken. Dem Logikteil 51 werden dazu über Verbindungen 52, 53 von den Frequenzdemodulatoren 20, 21 Stummschaltesignale zugeführt, die in den Frequenzdemodulatoren dann erzeugt werden, wenn diese über die Bandpaßfilter 18, 19 keine frequenzmodulierten Tonsignale erhalten. Von der Amplitudenregelanordnung 1 wird dem Logikteil 51 über eine Leitung 54 ein weiteres Stummschaltesignal und über eine Leitung 55 ein Quellenauswahlsignal zugeführt. Letzteres dient der Normumschaltung beim Wechsel vom Empfang z. B. eines B/G-Fernsehsignals zu einem L-Fernsehsignal und umgekehrt.

Die Stummschaltesignale und das Quellenauswahlsignal werden im Logikteil zu zwei Steuersignalen für die Quellenumschalter 35, 36 verknüpft, die diesen über Steuerleitungen 56, 57 zugeführt werden. Durch sie werden die Quellenumschalter 35, 36 derart gesteuert, daß beim Empfang eines Fernsehsignals z. B. nach der B/G-Norm mit einfachem Tonsignal nur der erste Frequenzdemodulator 20 über den Ausgang 27 das Tonsignal an den Eingang 33 der ersten Signalsenke liefert, während der zweite Frequenzdemodulator 21 für das zweite niederfrequente Tonsignal durch den Quellenumschalter 36 stummgeschaltet ist, d. h. der Ausgang 31 der Bezugsquelle ist mit dem Eingang 34 der zweiten Signalsenke verbunden. Beim Empfang z. B. eines B/G-Stereo- bzw. -Zweitonsignals ist auch der Ausgang 30 des zweiten Frequenzdemodulators 21 mit dem Eingang 34 der zweiten Signalsenke verbunden. Beim Empfang eines L-Fernsehsignales werden die Quellenumschalter auf die Ausgänge 29 bzw. 32 umgeschaltet. Tritt dagegen kein Fernsehsignal an den Zwischenfrequenzeingängen 14, 15 auf, werden durch das weitere Stummschaltesignal auf der Leitung 54 beide Quellenumschalter und damit beide Eingänge 33, 34 der Signalsenken stummgeschaltet. Einzelne Quellenumschalter 35 bzw. 36 können unabhängig von den der gesamten Schaltungsanordnung jeweils angebotenen Fernsehsignalen über die Verbindungen 52, 53 auch dann stummgeschaltet werden, wenn die Frequenzdemodulatoren 22, 21 Signalfehler oder Signalunterbrechungen detektieren. Die beschriebene Anordnung erfüllt damit gleichzeitig die Funktion einer Störungsunterdrückung.

Die Regelsignalerzeugungsstufe 3 der Amplitudenregelanordnung 1 umfaßt beim beschriebenen Ausführungsbeispiel neben der Erzeugung des Regelsignals für den Verstärker 2 auch die Funktion der Erzeugung des Quellenauswahlsignals, des weiteren Stummschaltesignals sowie der Steuerung des Umschalters 16. Das weitere Stummschaltesignal wird abhängig von der Erzeugung des Regelsignals dann erzeugt, wenn beim Absinken der Amplitude der Zwischenfrequenzsignale diese oder das Regelsignal für den Verstärker 2 und dadurch die Signalamplitude der Signalquelle einen Schwellenwert erreichen und damit signalisiert wird, daß die Zwischenfrequenzsignale derart schwach empfangen werden, daß daraus keine nutzbaren Tonsignale mehr gewonnen werden können, z. B. weil der Rauschpegel zu hoch wird.

Das Stummschalten kann auch durch einen Stummschaltebefehl ausgelöst werden, der der Schaltungsanordnung nach Fig. 1 von einer externen, nicht dargestellten Vorrichtung über einen Stummschalte-Befehlseingang 58 zugeleitet wird. Dieser betätigt einen Kurzschlußschalter 59, durch den ein mit der Regelsignalerzeugungsstufe 3 verbundener Regelkondensator 60 überbrückt und damit wirkungslos wird. Der Regelkondensator 60 ist auf eine Spannung aufgeladen, die aus dem Signal am Ausgang 5 des Verstärkers 2 abgeleitet ist und aus der für diesen das Regelsignal gewonnen wird. Die Verringerung dieser Spannung durch die Betätigung des Kurzschlußschalters 59 löst damit in der Regelsignalerzeugungsstufe 3 das Stummschaltesignal auf der Leitung 54 ebenso aus wie ein Abfall der Amplituden der Zwischenfrequenzsignale.

Die Regelsignalerzeugungsstufe 3 ist weiterhin mit einem Normumschalt-Befehlseingang 61 versehen, dem ein Normumschaltbefehl zugeleitet wird, durch den mit einem weiteren Kurzschlußschalter 62 ein L-Regelkondensator 63 kurzgeschlossen wird, wenn durch eine nicht dargestellte Schaltungsanordnung der Empfang z. B. eines B/G-Fernsehsignales erkannt wird. Im anderen Fall ist der Kurzschlußschalter 62 gesperrt. Über den Normumschalt-Befehlseingang 61 wird auf diese Weise zum einen die Regelcharakteristik der Regelsignalerzeugungsstufe 3 umgeschaltet, und zwar beispielsweise auf eine Spitzenwertregelung während der Synchronimpulsspitzen beim Empfang z. B. eines B/G-Fernsehsignales und auf eine Mittelwertregelung beim Empfang eines L-Fernsehsignales. Zum anderen wird daraus das Quellenauswahlsignal zur Weiterleitung über die Leitung 55 an den Logikteil 51 gewonnen.

Durch die gemeinsame externe Steuerung der Regelsignalerzeugungsstufe 3 und des Logikteils 51 können an letzterem externe Eingänge eingespart werden. Dies ist vorteilhaft für einen Aufbau der Schaltungsanordnung nach Fig. 1 als integrierte Halbleiterschaltung.

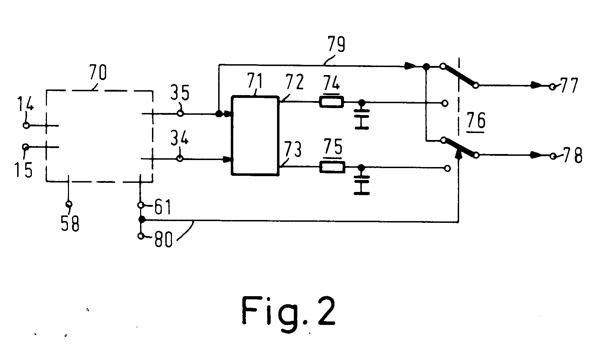

Fig. 2 zeigt ein grobschematisches Blockschaltbild für eine Anordnung zum Empfang und zur Verarbeitung eines Tonsignales in einem Mehrnormen-Fernsehempfänger. Darin ist die Schaltungsanordnung nach Fig. 1 mit 70 bezeichnet. Mit Fig. 1 übereinstimmende Teile sind mit identischen Bezugszeichen versehen. Von den Eingängen 33, 34 werden die niederfrequenten Tonsignale einem eine Signalsenke bildenden Stereo-Zweiton-Decoder 71 zugeführt, an dessen Ausgängen 72, 73 die Tonsignale für den linken bzw. rechten Stereo-Tonkanal geliefert werden. Sie durchlaufen je eine Entzerrerschaltung 74 bzw. 75 (Deemphase), die die senderseitig bei Frequenzmodulation vorgenommene Frequenzgangverzerrung rückgängig macht, und werden über einen Stereo-Quellenumschalter 76 einem Paar von Tonausgängen 77, 78 zugeführt. Für den Empfang eines L-Fernsehsignals mit einem einzigen niederfrequenten Tonsignal ist weiterhin vom Eingang 33 eine den Stereo-Zweiton-Decoder 71 und die Entzerrerschaltungen 74, 75 überbrükkende Leitung 79 unmittelbar an den Stereo-Quellenumschalter 76 geführt. Damit wird auch die fehlende senderseitige Frequenzgangverzerrung dieses Tonsignales berücksichtigt. Der Stereo-Quellenumschalter 76 wird über eine Normumschaltleitung 80 durch den Normumschaltbefehl gesteuert.

## Patentansprüche

1. Schaltungsanordnung zum wahlweisen Verbinden der Ausgänge einer Anzahl von aus Gleich- und Wechselanteilen bestehende Signale liefernden Signalquellen mit einem Eingang einer Signalsenke, in der alle von den Signalquellen (22, 23, 24 bzw. 22, 25, 26) an ihren Ausgängen (27 bis 32) abgegebenen Signale übereinstimmende Gleichanteile aufweisen,
dadurch gekennzeichnet, daß eine der Signalquellen (23 bis 26) als Bezugsquelle (24 bzw. 26) einen eingeprägten Gleichstrom liefert, der aus dem Gleichanteil eines von einer weiteren (23 bzw. 25) der Signalquellen gelieferten eingeprägten Stromes abgeleitet ist, daß die Ausgänge (27, 28 bzw. 30, 31) beider Quellen (23, 24 bzw. 25, 26) über je einen Widerstand (39, 40 bzw. 42, 43) mit einer Referenzspannung (41 bzw. 44) verbunden sind und die Produkte aus den Werten des Stromes und des Widerstandes (39, 40 bzw. 42, 43) für die Signalquelle (23, 25) und die Bezugsquelle (24, 26) gleich sind, daß die Bezugsquelle (24, 26) und die Signalquelle (23, 25) durch gleiche Signale führende Ausgangsanschlüsse einer Signalverarbeitungsstufe (20 bzw. 21) gebildet werden und daß an dem die Bezugsquelle bildenden Ausgangsanschluß (24 bzw. 26) der dort eingeprägte Gleichstrom abgetrennt und weitere Signalanteile unterdrückt werden.

2. Schaltungsanordnung nach Anspruch 1,
dadurch gekennzeichnet, daß eine (24 bzw. 26) der Signalquellen (22, 23, 24 bzw. 47, 25, 26) als Bezugsquelle eine Gleichspannung liefert und daß mit den Ausgängen (29 bzw. 32) weiterer (22) der Signalquellen Gleichspannungs-Einstellschaltungen (45, 46 bzw. 48, 49) verbunden sind, durch die die Gleichanteile der Signale an den Ausgängen (29 bzw. 32) der Signalquellen (22 bzw. 47) auf die Gleichspannung der Bezugsquelle (24 bzw. 26) eingestellt werden.

3. Schaltungsanordnung nach Anspruch 2,
dadurch gekennzeichnet, daß wenigstens eine der Gleichspannungs-Einstellschaltungen (45, 46 bzw. 48, 49) einen Koppelkondensator (45 bzw. 48) enthält, über den das Signal von der Signalquelle (22 bzw. 47) ihrem Ausgang (29 bzw. 32) zugeführt wird, sowie einen Widerstand (46 bzw. 49) zum Einspeisen der Gleichspannung an den Ausgang (29 bzw. 32).

4. Schaltungsanordnung nach Anspruch 1,
dadurch gekennzeichnet, daß die Ausgangsanschlüsse (23, 24 bzw. 25, 26) der Signalverarbeitungsstufe (20 bzw. 21) durch eine Stromspiegelanordnung gebildet sind.

5. Schaltungsanordnung nach einem oder mehreren der vorhergehenden Ansprüche,
dadurch gekennzeichnet, daß die Signalquellen Tonsignale abgeben.

6. Schaltungsanordnung nach einem der vorhergehenden Ansprüche,
gekennzeichnet durch eine Steuerschaltung (51; 35, 36), der ein Quellenauswahlsignal (auf 55) zugeführt wird und die danach den Eingang (33 bzw. 34) der Signalsenke mit dem Ausgang (27 bis 32) einer ausgewählten Signalquelle (22, 23, 24 bzw. 47, 25, 26) verbindet, und der wenigstens ein Stummschaltesignal (auf 52, 53, 54) zugeleitet wird, durch das sie den Eingang (33 bzw. 34) der Signalsenke vorrangig mit dem Ausgang (28 bzw. 31) der Bezugsquelle (24 bzw. 26) verbindet.

7. Schaltungsanordnung nach Anspruch 6,
dadurch gekennzeichnet, daß die Signalverarbeitungsstufe (20 bzw. 21) das Stummschaltesignal (auf 52 bzw. 53) erzeugt, wenn die durch sie gebildete Signalquelle (23 bzw. 25) kein Signal abgibt.

8. Schaltungsanordnung nach Anspruch 6 oder 7,
dadurch gekennzeichnet, daß in einer Mehrnormen-Fernseh-Empfangsanordnung, die für das Tonsignal jeder Fernsehnorm eine eine Signalquelle (22, 47 bzw. 23, 25) bildende Signalverarbeitungsstufe (6 bzw. 7, 18, 19, 20, 21) aufweist, eine der Signalverarbeitungsstufen (7, 18, 19, 20, 21) weiterhin eine Bezugsquelle (24 bzw. 26) bildet und die Ausgänge der übrigen (22, 47) mit Gleichspannungseinstellschaltungen (45, 46 bzw. 48, 49) verbunden sind.

9. Schaltungsanordnung nach Anspruch 6, 7 oder 8,
gekennzeichnet durch eine Amplitudenregelanordnung (1) zum Einstellen aufeinander abgestimmter Signalamplituden der Signalquellen (22 bis 26, 47) und mit für einzelne Signalquellen umschaltbarem Regelverhalten, die ferner der Steuerschaltung (51; 35, 36) das Quellenauswahlsignal (auf 55) zuleitet sowie ein Stummschaltesignal (auf 54), wenn die Signalamplitude der ausgewählten Signalquelle unter einen Schwellenwert absinkt.

10. Schaltungsanordnung nach Anspruch 9,
dadurch gekennzeichnet, daß das Regelverhalten der Amplitudenregelanordnung (1) durch wenigstens einen Regelkondensator (60, 63) bestimmt wird und zur Erzeugung des Quellenauswahlsignals (auf 55) und des Stummschaltesignals (auf 54) die Regelkondensatoren (60, 63) durch einen extern zugeführten Stummschalte- oder Normumschaltebefehl wahlweise wirkungslos geschaltet werden.

11. Schaltungsanordnung nach Anspruch 8 oder einem der Ansprüche 9 oder 10 in Verbindung mit Anspruch 8,
gekennzeichnet durch einen Umschalter (16), über den wahlweise ein erstes Zwischenfrequenzsignal von einem ersten Zwischenfrequenzeingang (14) oder ein zweites Zwischenfrequenzsignal von einem zweiten Zwischenfrequenzeingang (15) über eine Amplitudenregelanordnung (1) jeweils einer der Signalverarbeitungsstufen (6 bzw. 7, 18, 19, 20, 21) zugeführt wird.

## Claims

1. A circuit arrangement for optionally connecting the outputs of a plurality of signal sources which produce signals consisting of d.c. and a.c. components to an input of a signal sink, in which all the signals supplied by the signal sources (22, 23, 24 and 22, 25, 26, respectively) from their outputs (27 to 32) have corresponding d.c. components, characterized in that one of the signal sources (23 to 26) produces as the reference source (24 or 26, respectively) an impressed direct current which is derived from the d.c. component of an impressed current supplied by a further one (23 or 25, respectively) of the signal-sources, in that the outputs (27, 28 and 30, 31, respectively) of the two sources (23, 24 and 25, 26, respectively) are connected each via a resistor (39, 40 and 42, 43, respectively) to a reference voltage (41 or 44, respectively) and the products of the values of the current and of the resistor (39, 40 and 42, 43, respectively) are the same for the signal sources (23, 25) and the reference sources (24, 26), in that the reference sources (24, 26) and the signal sources (23, 25) are constituted by output terminals carrying the same signals of a signal processing stage (20 or 21 respectively) and in that at the output terminal (24 or 26, respectively) constituting the reference source the direct current impressed there is separated and further signal components are suppressed.

2. A circuit arrangement as claimed in Claim 1, characterized in that one (24 or 26) of the signal sources (22, 23, 24 and 47, 25, 26, respectively) produces as a reference source a d.c. voltage and in that d.c. voltage setting circuits (45, 46 and 48, 49, respectively) are connected to the outputs (29 or 32) of further (22) signal sources, which match the d.c. components of the signals at the outputs (29 or 32) of the signal sources (22 or 47, respectively) to the d.c. voltage of the reference sources (24 or 26, respectively).

3. A circuit arrangement as claimed in Claim 2, characterized in that at least one of the d.c. voltage setting circuit (45, 46 and 48, 49, respectively) includes a coupling capacitor (45 or 48, respectively) via which the signal from the signal source (22 or 47, respectively) is applied to its output (29 or 32, respectively), and also a resistor (46 or 49, respectively) for applying the d.c. voltage to the output (29 or 32, respectively).

4. A circuit arrangement as claimed in Claim 1, characterized in that the output terminals (23, 24 and 25, 26, respectively) of the signal processing stage (20 or 21, respectively) are constituted by a current mirror arrangement.

5. A circuit arrangement as claimed in one or more of the preceding Claims, characterized in that the signal sources supply sound signals.

6. A circuit arrangement as claimed in any one of the preceding Claims, characterized by a control circuit (51; 35, 36) to which a source selection signal is applied (to 55) and which subsequently connects the input (33 or 34, respectively) of the signal sink to the output (27 to 32) of a selected signal source (22, 23, 24 and 47, 25, 26, respectively), and to which at least one muting signal is applied (to 52, 53, 54), by which it connects the input (33 or 34, respectively) of the signal sink with priority to the output (28 or 31, respectively) of the reference source (24 or 26).

7. A circuit arrangement as claimed in Claim 6, characterized in that the signal processing stage (20 or 21) generates the muting signal when the signal source (23 or 25) constituted thereby does not supply a signal.

8. A circuit arrangement as claimed in Claim 6 or 7, characterized in that in a multi-standard television receiver arrangement which includes for the sound signal of each television standard a signal processing stage (6 and 7, 18, 19, 20, 21, respectively) which constitutes a signal source (22, 47 and 23, 25, respectively), one of the signal processing stages (7, 18, 19, 20, 21) further constitutes a reference source (24 or 26, respectively) and the outputs of the remaining sources (22, 47) are connected to d.c. voltage setting circuits (45, 46 and 48, 49, respectively).

9. A circuit arrangement as claimed in Claim 6, 7, or 8, characterized by an amplitude control arrangement (1) for setting mutually matched signal amplitudes of the 5 signal sources (22 to 26, 47) and having a control characteristic which is switchable for individual signal sources, which arrangement further applies the source selection signal (at 55) to the control circuit (51, 35, 36) and also a muting signal (at 54) when the signal amplitude of the selected signal source decreases to below a threshold value.

10. A circuit arrangement as claimed in Claim 9, characterized in that the control characteristic of the amplitude control arrangement (1) is determined by at least one control capacitor (60, 63), and for the purpose of generating the source selection signal (at 55) and the muting signal (at 54) the control capacitors (60, 63) are optionally made inoperative by means of an externally applied muting or standard-changeover command.

11. A circuit arrangement as claimed in Claim 8 or any one of Claim 9 or 10 where appendant to Claim 8, characterized by a change-over switch (16) via which optionally a first intermediate frequency signal from a first intermediate frequency input (14) or a second intermediate frequency signal from a second intermediate frequency input (15) is applied to one of the signal processing stages (6 or 7, 18, 19, 20, 21, respectively) via an amplitude control arrangement (1).

## Revendications

1. Circuit de connexion sélective des sorties d'un certain nombre de sources de signaux délivrant des signaux constitués de fractions continues et de fractions alternatives à une entrée d'un collecteur de signaux, dans lequel tous les signaux délivrés par les sources de signaux (22, 23, 24 ou 22, 25, 26) à leurs sorties (27 à 32) présentent des fractions continues correspondantes, caractérisé en ce que l'une des sources de signaux (23 à 26) fournit, à titre de source de référence (24 ou 26), un courant continu superposé, qui est dérivé de la fraction continue d'un courant superposé délivrée par une autre (23 ou 25) des sources de signaux, que les sorties (27, 28 ou 30, 31) des deux sources (23, 24 ou 25, 26) sont connectées via, chaque fois une résistance (39, 40 ou 42, 43) à une tension de référence (41 ou 44) et les produits des valeurs du courant et de la résistance (39, 40 ou 42, 43) sont égaux pour la source de signaux (23, 25) et la source de référence (24, 26), que la source de référence (24, 26) et la source de signaux (23, 25) sont formées par des connexions de sortie d'un étage de traitement de signaux (20 ou 21) acheminant les mêmes signaux et que, à la connexion de sortie (24 ou 26) formant la source de référence, le courant continu qui y est superposé est séparé et d'autres fractions de signaux sont supprimées.

2. Circuit de connexion selon la revendication 1, caractérisé en ce qu'une (24 ou 26) des sources de signaux (22, 23, 24 ou 47, 25, 26) délivre en tant que source de référence une tension continue et que sont connectées aux sorties (29 ou 32) d'une autre (22) des sources de signaux des dispositifs de réglage de tension continue (45, 46 ou 48, 49), grâce auxquels les fractions continues de signaux aux sorties (29 ou 32) des sources de signaux (22 ou 47) sont réglées sur la tension continue de la source de référence (24 ou 26).

3. Dispositif de connexion selon la revendication 2, caractérisé en ce qu'au moins l'un des dispositifs de réglage de tension continue (45, 46 ou 48, 49) contient un condensateur de couplage (45 ou 48) par lequel le signal de la source de signaux (22 ou 47) est amené à sa sortie (29 ou 32), ainsi qu'une résistance (46 ou 49) pour fournir la tension continue à la sortie (29 ou 32).

4. Dispositif de connexion selon la revendication 1, caractérisé en ce que les connexions de sortie (23, 24 ou 25, 26) de l'étage de traitement de signaux (20 ou 21) sont formées par un dispositif à miroir de courant.

5. Dispositif de connexion selon une ou plusieurs des revendications précédentes, caractérisé en ce que les sources de signaux délivrent des signaux sonores.

6. Dispositif de connexion selon l'une quelconque des revendications précédentes, caractérisé par un dispositif de commande (51; 35, 36), auquel est fourni un signal de sélection de source (en 55) et qui connecte ensuite l'entrée (33 ou 34) du collecteur de signaux à la sortie (27 à 32) d'une source de signaux sélectionnée (22, 23, 24 ou 47, 25, 26) et auquel est amené au moins un signal de commutation silencieuse (52, 53, 54) grâce auquel il connecte l'entrée (33 ou 34) du collecteur de signaux en priorité à la sortie (28 ou 31) de la source de référence (24 ou 26).

7. Dispositif de connexion selon la revendication 6, caractérisé en ce que l'étage de traitement de signaux (20 ou 21) produit le signal de commutation silencieuse (en 52 ou 53) lorsque la source de signaux formée par cet étage (23 ou 25) ne délivre pas de signal.

8. Dispositif de connexion selon la revendication 6 ou 7, caractérisé en ce que, dans un dispositif de réception de télévision à standards multiples, qui présente pour le signal sonore de chaque standard de télévision un étage de traitement de signaux (6 ou 7, 18, 19, 20, 21) formant une source de signaux (22, 47 ou 23, 25), un des étages de traitement de signaux (7, 18, 19, 20, 21) forme, en outre, une source de référence (24 ou 26) et les sorties des autres sources de signaux (22, 47) sont connectées à des circuits de réglage de tension continue (45, 46 ou 48, 49).

9. Dispositif de connexion selon la revendication 6, 7 ou 8, caractérisé par un dispositif de régulation d'amplitude (1) pour régler les amplitudes de signaux des sources de signaux (22 à 26, 47) réglées l'une sur l'autre et avec une régulation qui peut être commutée pour les sources de signaux individuelles, qui amène, en outre, au circuit de commande (51; 35, 36) le signal de sélection de source (en 55) ainsi qu'un signal de commutation silencieuse (en 54) lorsque l'amplitude de signal de la source de signaux sélectionnée descend en dessous d'une valeur de seuil.

10. Dispositif de connexion selon la revendication 9, caractérisé en ce que la régulation du dispositif de régulation d'amplitude (1) est déterminée par au moins un condensateur de régulation (60, 63) et, pour produire le signal de sélection de source (en 55) et le signal de commutation silencieuse (en 54), les condensateurs de régulation (60, 63) sont mis hors circuit par une instruction de commutation silencieuse ou de commutation de standards acheminée de manière externe, au choix.

11. Dispositif de connexion selon la revendication 8 ou selon l'une des revendications 9 ou 10 en liaison avec la revendication 8, caractérisé par un commutateur (16) via lequel, au choix, un premier signal de fréquence intermédiaire est amené à partir d'une première entrée de fréquence intermédiaire (14) ou un deuxième signal de fréquence intermédiaire est amené à partir d'une deuxième entrée de fréquence intermédiaire (15), via un dispositif de régulation d'amplitude (1), chaque fois à l'un des étages de traitement de signaux (6 ou 7, 18, 19, 20, 21).
